# EUROPEAN PATENT SPECIFICATION

(11) **EP 1 980 953 B1**
(45) Date of publication and mention of the grant of the patent: **18.07.2018**
(21) Application number: 07707240.3
(22) Date of filing: 23.01.2007
(51) Int. Cl.: G06F 3/0488, G06F 9/44

(54) **CHARACTER INPUT DEVICE**
ZEICHENEINGABEEINRICHTUNG
DISPOSITIF DE SAISIE DE CARACTÈRE

(30) Priority: 30.01.2006 JP 2006020642
(43) Date of publication of application: 15.10.2008
(73) Proprietor: KYOCERA CORPORATION, Kyoto-shi, Kyoto 612-8501 (JP)
(72) Inventor: KUMAMOTO, Tetsushi, Yokohama-shi Kanagawa 224-8502 (JP)
(74) Representative: Viering, Jentschura & Partner mbB Patent- und Rechtsanwälte
(86) International application number: PCT/JP2007/050977
(87) International publication number: WO 2007/086371

(56) References cited:
- JP-A- 08 317 041
- JP-A- 09 128 134
- US-A- 5 812 117
- US-A1- 2002 167 545
- US-A1- 2003 119 543
- US-A1- 2003 197 687
- US-A1- 2004 140 956
- US-A1- 2005 154 798
- "SOFT ADAPTIVE FOLLOW-FINGER KEYBOARD FOR TOUCH-SCREEN PADS" IBM TECHNICAL DISCLOSURE BULLETIN, IBM CORP. NEW YORK, US, vol. 36, no. 11, 1 November 1993 (1993-11-01), pages 5-07, XP000424761 ISSN: 0018-8689
- MACKENZIE I S ET AL: "THE DESIGN AND EVALUATION OF A HIGH-PERFORMANCE SOFT KEYBOARD" CHI '99 CONFERENCE PROCEEDINGS HUMAN FACTORS IN COMPUTING SYSTEMS. PITTSBURGH, PA, MAY 15 - 20, 1999; [CHI CONFERENCE PROCEEDINGS. HUMAN FACTORS IN COMPUTING SYSTEMS], NEW YORK, NY : ACM, US, 15 May 1999 (1999-05-15), pages 25-31, XP000894201 ISBN: 978-0-201-48559-2
- "FUNCTION-INDEPENDENT APPROACH TO DRIVING SOFT KEYBOARDS" IBM TECHNICAL DISCLOSURE BULLETIN, IBM CORP. NEW YORK, US, vol. 33, no. 4, 1 September 1990 (1990-09-01), pages 159-161, XP000106377 ISSN: 0018-8689
- JUHA KELA ET AL: "Accelerometer-based gesture control for a design environment", PERSONAL AND UBIQUITOUS COMPUTING, SPRINGER VERLAG, LO, vol. 10, no. 5, 23 August 2005 (2005-08-23), pages 285-299, XP019431199, ISSN: 1617-4917

## Description

### TECHNICAL FIELD

The present invention relates to a character input device.

### BACKGROUND ART

Small character input devices, such as mobile telephones, PDAs, and the like, include devices in which a software keyboard is disposed on a touch screen, and input in a full keyboard environment is possible. Such software keyboards are unavoidably smaller than hardware keyboards provided in personal computers and the like; accordingly, various devices have been devised.

For example, in the software keyboard described in "Pocket LOOX User Guide", "4. Character Input in Input Panel", (online), June 2004, Fujitsu Co., Ltd., (Search January 14, 2006), (website: http://www.fmworld.net/biz/pda/manual/0407/), a combo box for selecting a keyboard arrangement is disposed on a part of the keyboard, and the keyboard arrangement that is displayed is altered in accordance with the selection made by the user. If this is done, then even if the individual keys are small and a plurality of characters (kana (a Japanese syllabary) and alphabetic characters) cannot be displayed on each key, both kana input and Roman character input can be realized. Patent document US2002/167545 discloses an input window including input fields, displayed on a touch screen of a portable information terminal in response to a data input request. A soft keyboard comprising a character set corresponding to a selected input field is identified and displayed on a data entry screen. A specified key on the keyboard is pressed for switching between different soft keyboards (languages).

### DISCLOSURE OF THE INVENTION

### Problems to be Solved by the Invention

In the software keyboard described in the abovementioned "Pocket LOOX User Guide", "4. Character Input in Input Panel", (online), June 2004, Fujitsu Co., Ltd., (Search January 14, 2006), (website: http://www.fmworld.net/biz/pda/manual/0407/), an operation is required in which a combo box corresponding to the desired arrangement is selected in order to alter the keyboard arrangement. However, due limitations on the display area, the combo boxes are also unavoidably small, and the operation involved in altering the keyboard arrangement is extremely difficult.

Accordingly, it is one object of the present invention to provide a character input device which makes it possible to alter the keyboard arrangement displayed on the touch screen even by a simple operation.

### Means for Solving the Problems

The character input device of the present invention used to solve the abovementioned problems is characterized in comprising memory means for storing a plurality of different types of keyboard arrangement images; display means for displaying one of the plurality of different types of keyboard arrangement images on a touch screen; touch operation judgment means for judging whether or not a touch operation has been performed in a specified area of the touch screen; and display switching control means for controlling the display means so that one of the keyboard arrangement images among the keyboard arrangement images stored by the memory means, other than the keyboard arrangement image that is being displayed by the display means, is displayed in cases where a judgment is made by the judgment means that a touch operation has been performed.

According to this aspect of the present invention, the user can switch the keyboard arrangement image merely by performing a touch operation (operation in which the touch screen is touched) on a specified area within the touch screen; accordingly, the keyboard arrangement displayed on the touch screen can be altered even by a simple operation.

Furthermore, according to the character input device described above, a system may be used in which the memory means stores at least three types of keyboard arrangement images in an assigned order; the character input device further comprises movement operation judgment means for judging whether or not a point of contact has moved in cases where the touch operation judgment means has judged that a touch operation has been performed; and the display switching control means controls the display means so that in cases where the movement operation judgment means judges that the contact point has moved, one of the two types of keyboard arrangement images stored following the keyboard arrangement image that is being displayed by the display means is selected in accordance with the direction of movement, and the selected keyboard arrangement image is displayed.

According to this aspect of the present invention, the user can designate one of the stored keyboard arrangement images, and switch [the keyboard arrangement image], merely by performing a touch operation using a stylus, and then moving the contact point between the stylus and the touch screen in a state in which the touch screen is touched.

Furthermore, in the character input device described in each of the abovementioned aspects, the system may be devised so that the specified area of the touch screen is an area other than the areas to which a key is assigned in the keyboard arrangement image that is being displayed by the display means.

According to this aspect of the present invention, the user can use a touch operation to switch the keyboard arrangement image in an arbitrary area other than the areas to which keys are assigned in the keyboard arrangement images. Accordingly, the keyboard arrangement displayed on the touch screen can be altered by a simple operation performed in a broad area.

Furthermore, in the character input device described in the abovementioned aspects, the system may be devised so that the character input device also functions as a telephone; the memory means stores dial key arrangement images in addition to the plurality of different types of keyboard arrangement images; the character input device is activated by either a keyboard operating mode, in which one of the keyboard arrangement images stored by the memory means is displayed by the display means, or a dial key operating mode, in which a dial key arrangement image stored by the memory means is displayed by the display means; and the character input device further comprises operating mode switching means for receiving an operating mode switching operation performed by the user, and switches the display produced by the display means in accordance with the received switching operation.

According to this aspect of the present invention, the character input device can be used as a telephone by switching the operating mode.

Furthermore, the mobile communication device of the present invention is characterized in comprising the abovementioned character input device. According to this aspect of the present invention, alteration of the keyboard arrangement displayed on the touch screen can be accomplished even by a simple operation in a mobile communication device such as a mobile telephone or the like.

### BRIEF DESCRIPTION OF THE DRAWINGS

FIG. 1 is a perspective view of a PDA in an embodiment of the present invention;
FIG. 2 is a diagram showing a software keyboard in an embodiment of the present invention;
FIG. 3 is a diagram showing a keyboard arrangement image in an embodiment of the present invention;
FIG. 4 is a diagram showing dial keys in an embodiment of the present invention;
FIG. 5 is a diagram showing functional blocks of the PDA in an embodiment of the present invention;
FIG. 6 is an explanatory diagram used to illustrate the process for determining the keyboard arrangement image that is displayed on the touch screen in the PDA of an embodiment of the present invention;
FIG. 7 is a diagram showing the screen transition of the touch screen in an embodiment of the present invention; and
FIG. 8 is a perspective view of a mobile telephone according to a modification example of an embodiment of the present invention.

### BEST MODE FOR CARRYING OUT THE INVENTION

Embodiments of the present invention will be described with reference to the attached drawings.

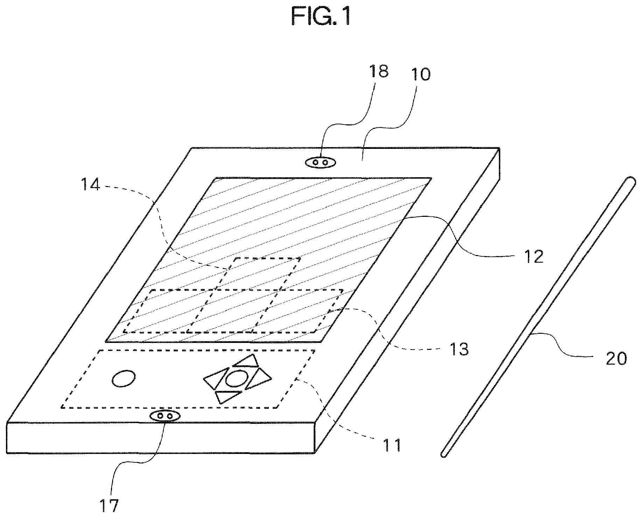

FIG. 1 is a perspective view of the PDA 10 (personal digital assistant) in the present embodiment. As is shown in FIG. 1, the PDA 10 comprises hardware operating keys 11, a touch screen 12, a microphone 17, and a speaker 18.

The PDA 10 also functions as a mobile telephone, and operates in either a keyboard operating mode in which a software keyboard is displayed on the touch screen 12, or dial key operating mode in which dial keys are displayed on the touch screen 12. These operating modes are switched by a specified operating mode switching operation performed by the user.

In the keyboard operating mode, the PDA 10 displays a software keyboard in the area 13 of the touch screen 12. The user performs software keyboard operations by touching the touch screen 12 using a stylus 20. Character input into the PDA 10 is performed by operating this software keyboard, and the PDA 10 can be caused to function as a character input device. The PDA 10 displays the characters that are thus input in a specified area of the touch screen 12.

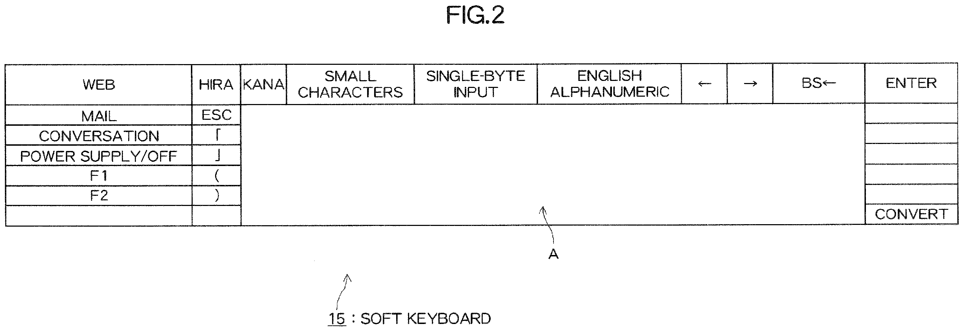

FIG. 2 is a diagram showing an example of the software keyboard 15 displayed in the area 13. The software keyboard 15 shown in FIG. 2 has a fixed display area which has various types of keys such as "WEB", "hira", "kana", and the like, and a variable area A. Furthermore, the "conversation" key included in the fixed display area is an off-hook/on-hook key. As a result of this "conversation" key, the user can initiate a conversation in cases where an incoming call is received even in the keyboard operating mode. The conversation is carried on via the microphone 17 and speaker 18.

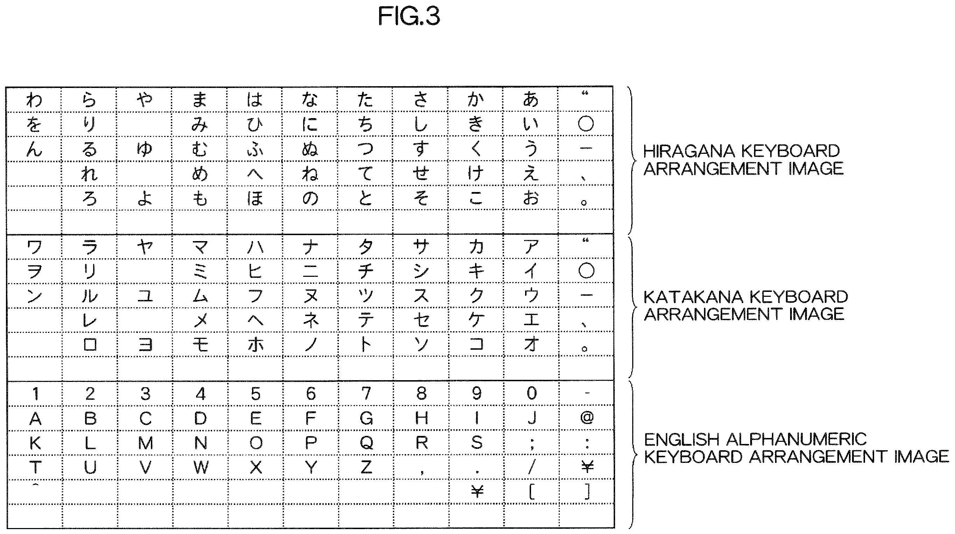

FIG. 3 is a diagram showing one example of the keyboard arrangement image displayed in the variable area A. Here, as is shown in this figure, three types of images, i.e., "hiragana (one type of Japanese syllabary) keyboard arrangement image", "katakana (another type of Japanese syllabary) keyboard arrangement image", and "alphanumeric keyboard arrangement image", are used as keyboard arrangement images. Each of these screens is selected by an operation performed by the user. The selected screen is displayed in the area A.

In the dial key operating mode, the PDA 10 displays the dial keys in the area 14 of the touch screen 12. In cases where the user makes a telephone call, the user switches the operating mode to the dial key operating mode.

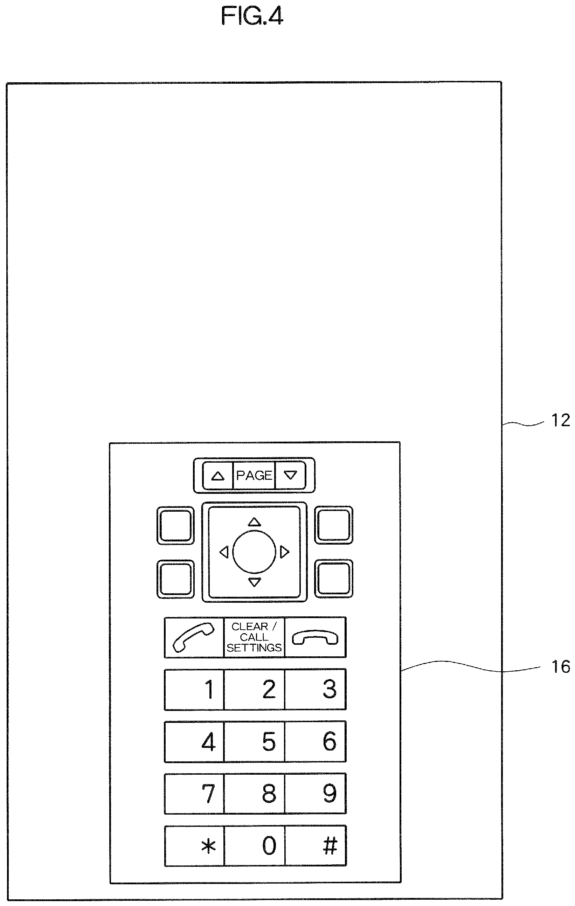

FIG. 4 is a diagram showing one example of the dial keys 16 displayed in the area 14. As is shown in FIG. 4, the dial keys 16 comprise various types of keys that are necessary in a mobile telephone, such as an off-hook key, on-hook key, number keys "0" through "9", and the like. When the user inputs a telephone number using the number keys, and then presses the off-hook key, the PDA 10 makes a call to the input telephone number. Furthermore, each time that a number key is pressed, the PDA 10 displays the numeral or character corresponding to the pressed number key in a specified area of the touch screen.

Details of the function of the PDA 10 will be described below.

The PDA 10 is a computer comprising a CPU and a memory. The CPU is a processing unit which is used to execute programs stored in the memory. This CPU performs processing that controls various parts of the PDA 10, and performs various functions described later. The memory stores programs and data used to work the present embodiment, and also acts as the working memory of the CPU.

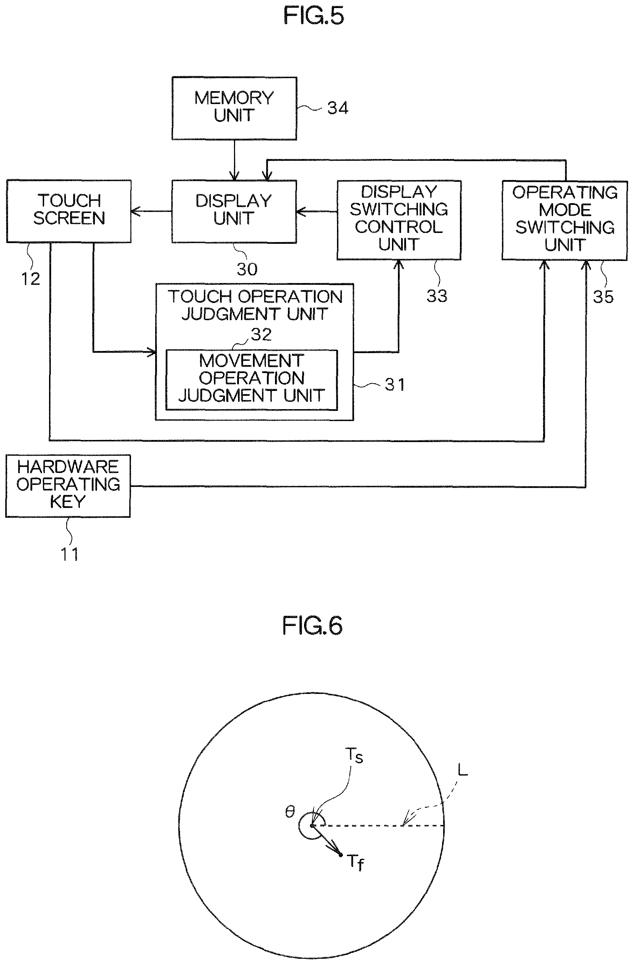

FIG. 5 is a diagram showing functional blocks of the PDA 10 (excluding the wireless communication unit, conversation circuit unit, and the like). As is shown in FIG. 5, the PDA 10 comprises, in functional terms, a display unit 30, a touch operation judgment unit 31, a display switching control unit 33, a memory unit 34, and an operating mode switching unit 35. Furthermore, the touch operation judgment unit 31 further comprises a movement operation judgment unit 32.

The memory unit 34 stores each of the keyboard arrangement images shown in FIG. 3. In the present embodiment, three types of keyboard arrangement images are stored in an assigned order. Furthermore, the memory unit 34 stores a fixed display keyboard arrangement image used to display the fixed display area of the software keyboard 15. Moreover, the memory unit 34 stores a dial key arrangement image used to display the dial keys 16.

The operating mode switching unit 35 receives operating mode switching operations performed by the user. A touch operation in a specified area of the touch screen 12, a touch operation on the hardware operating key 11, and the like may be cited as concrete examples of operating mode switching operations. A touch operation performed by the user using the "conversation" key (FIG. 2) at times other than during conversation or incoming calls may be cited as a more concrete example.

The operating mode switching unit 35 switches the display unit 30 in accordance with the operation thus received. In concrete terms, in cases where the operating mode switching unit 35 has been in the keyboard display operating mode up to this point, the operating mode switching unit switches to the dial key display operating mode, and in cases where the operating mode switching unit has been in the dial key display operating mode, up to this point, the operating mode switching unit switches to the keyboard display operating unit. Furthermore, in the keyboard display operating mode, the operating mode switching unit 35 causes the display unit 30 to display both the fixed display key arrangement screen stored in the memory unit 34 and one of the keyboard arrangement images likewise stored in the memory unit 34. Moreover, in the dial key display operating mode, the operating mode switching unit 35 causes the display unit 30 to display the dial key arrangement image stored in the memory unit 34.

Below, the processing performed in each part constituting the PDA 10 when a keyboard arrangement image is selected by the user in the keyboard display operating mode will be described.

In the keyboard display operating mode, the display unit 30 displays the fixed display key arrangement screen stored in the memory unit 34 in the area 13 under the control of the operating mode switching unit 35. Furthermore, the display unit 30 also selects one of the keyboard arrangement images stored in the memory unit 34 as instructed by the display switching control unit 33 described later, and displays this in the area A of the displayed fixed display key arrangement screen.

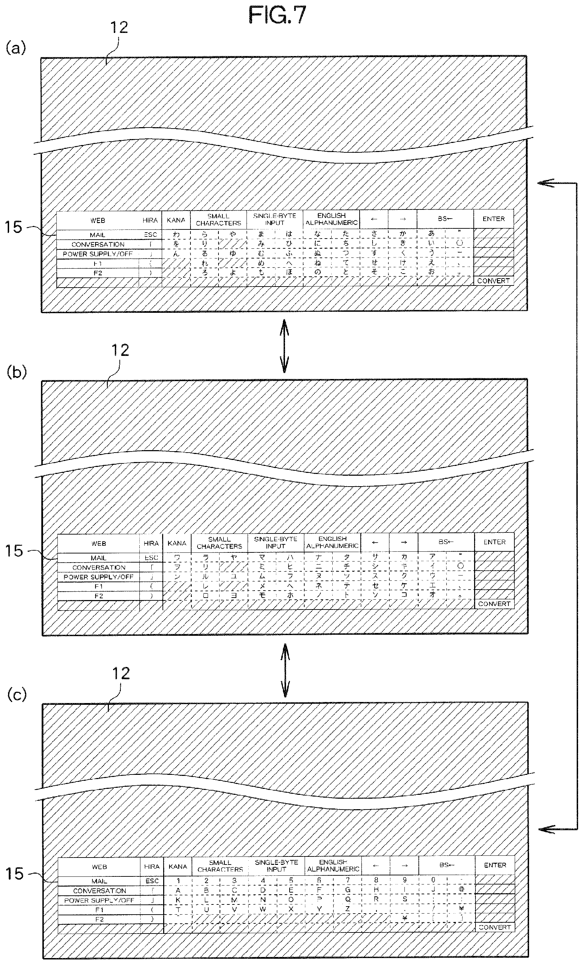

The touch operation judgment unit 31 judges whether or not a touch operation has been performed by the user in a specified area of the touch screen 12. This touch operation is an operation in which the touch screen 12 is touched with a stylus 20 or the like. Here, in particular, the touch operation judgment unit 31 judges whether or not a touch operation has been performed by the user respectively in areas to which no key has been assigned in the software keyboard 15 (see FIG. 7 described later), or areas to which a key for character input or the like has been separately assigned.

In cases where the touch operation judgment unit 31 judges that a touch operation has been performed in an area to which no key is assigned in the software keyboard 15, the movement operation judgment unit 32 further judges whether or not the contact point has moved. Specifically, the movement operation judgment unit 32 judges whether or not the user has moved the stylus 20 while maintaining contact with the touch screen 12. More concretely, the movement operation judgment unit 32 constantly acquires the coordinates of the point where the stylus 20 touches the touch screen (contact point), and judges whether or not the contact point has moved by judging whether or not these coordinates have changed by a specified amount or greater up to the point where the stylus 20 is removed from the touch screen.

In cases where it is judged that the contact point has moved, the movement operation judgment unit 32 outputs signals indicating that a touch operation has been performed in a specified area, and indicates the direction of movement of the contact point, to the display switching control unit 33. On the other hand, in cases where it is judged that the contact point has not moved, the movement operation judgment unit 32 outputs a signal indicating that a touch operation has been performed in a specified area to the display switching control unit 33.

In cases where a signal indicating that a touch operation has been performed is input by the movement operation judgment unit 32, the display switching control unit 35 controls the display unit 30 so that one of the keyboard arrangement images among the keyboard arrangement images stored in the memory unit 34, other than the keyboard arrangement image currently being displayed, is displayed. Furthermore, in cases where a signal indicating the direction of movement of the contact point is also input by the movement operation judgment unit 32, the display switching control unit 33 selects one of the two types of keyboard arrangement images stored following the keyboard arrangement image that is being displayed in accordance with the direction of movement, and controls the display unit 30 so that this selected keyboard arrangement image is displayed.

The abovementioned control of the display switching control unit 33 will be described more concretely. The memory unit 34 stores three types of keyboard arrangement images by a cycling arrangement in the order "hiragana keyboard arrangement image", "katakana keyboard arrangement image", and "alphanumeric keyboard arrangement image". For example, in cases where the "hiragana keyboard arrangement image" is stored by the display unit 30, if signals indicating that a touch operation has been performed, and indicating the direction of movement of the contact point, are input, the display switching control unit 33 causes the display unit 30 to display one of the two keyboard arrangement images stored following the keyboard arrangement image, i.e., the "alphanumeric keyboard arrangement image" stored "before" the "hiragana keyboard arrangement image" or the "katakana keyboard arrangement image" stored "after" the "hiragana keyboard arrangement image", in accordance with the direction of movement.

FIG. 6 is an explanatory diagram used to illustrate the processing whereby the display switching control unit 33 determines the keyboard arrangement image that is displayed by the display unit 30. In FIG. 6, Ts indicates the contact point of the touch operation. The movement operation judgment unit 32 acquires the point Tf at which the stylus 20 is removed from the touch screen 12 following the touch operation. Furthermore, in cases where the distance between these points are not greater than or equal to a specified amount, it is judged that the contact point has not moved. On the other hand, in cases where the distance between these points are greater than or equal to a specified amount, the angle θ formed with a specified direction L by the straight line formed by the point Tf with the point Ts is acquired. The movement operation judgment unit 32 outputs a signal indicating this angle θ as the abovementioned signal indicating the direction of movement of the contact point.

In cases where the angle θ is 0 degrees or greater but less than 180 degrees, the display switching control unit 33 causes the display unit 30 to select the "alphanumeric keyboard arrangement image" which is stored "before" the "hiragana keyboard arrangement image". Furthermore, in cases where the angle θ is 180 degrees or greater but less than 360 degrees, the display switching control unit 33 causes the display unit 30 to select the "katakana keyboard arrangement image" which is stored "after" the "hiragana keyboard arrangement image" . In this way, the display switching control unit 33 determines the keyboard arrangement image displayed by the display unit 30 in accordance with the direction of movement of the contact point.

The display unit 30 reads out a keyboard arrangement image from the memory unit 34 under the control of the display switching control unit 33, and updates the display in the area A using this read-out keyboard arrangement image.

The selection of the keyboard arrangement image described above will be described in greater detail with reference to FIG. 7.

FIG. 7 is a diagram showing concrete examples of the screen transition of the touch screen 12 in the keyboard display operating mode. FIGS. 7(a), 7(b), and 7(c) respectively show the states in which the "hiragana keyboard arrangement image", "katakana keyboard arrangement image", and "alphanumeric keyboard arrangement image" are displayed on the touch screen 12.

The display switching control unit 33 controls the display unit 30 so that either a screen selection in the order (a) --> (b) --> (c) --> (a) or a screen selection in the order (a) --> (c) --> (b) --> (a) is executed in accordance with the direction of movement of the contact point output from the movement operation judgment unit 32.

Furthermore, the touch operation judgment unit 31 judges whether or not a touch operation has been performed by the user in the areas indicated by shading in each of FIGS. 7(a), 7(b) and 7(c). These areas differ according to the keyboard arrangement image as indicated in FIG. 7; the touch operation judgment unit 31 judges whether or not a touch operation has been performed by the user in areas that differ according to the keyboard arrangement image that is being displayed by the display unit 30.

In the PDA 10 of the present embodiment, as was described above, the user can switch the keyboard arrangement image merely by performing a touch operation (operation in which the touch screen is touched) using a stylus 20 in a specified area of the touch screen 12; accordingly, the keyboard arrangement displayed on the touch screen 12 can be altered even with a simple operation. Furthermore, by setting this specified area as an arbitrary area other than the areas to which keys are assigned in the keyboard arrangement image, the user can alter the keyboard arrangement displayed on the touch screen 12 using a simple operation performed in a broad area.

Furthermore, the user can select and switch any of the stored keyboard arrangement images merely by moving the contact point between the stylus 20 and touch screen 12 in a state in which the touch screen 12 is touched following the abovementioned touch operation using the stylus 20.

Furthermore, the PDA 10 can also be used as a telephone by switching the operating mode.

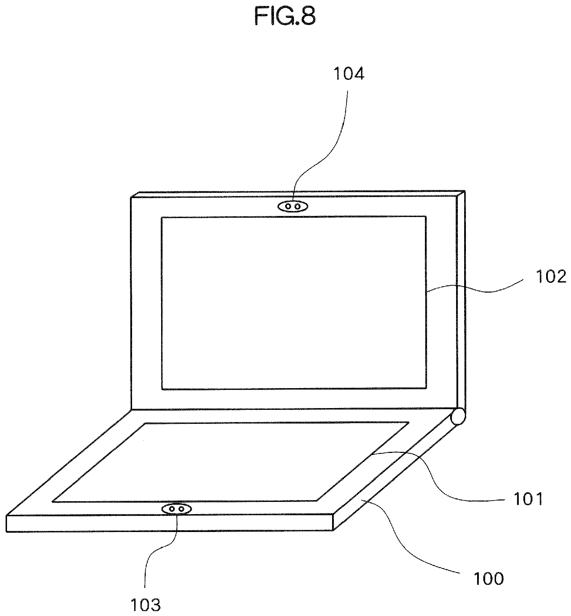

Moreover, the present invention is not limited to the abovementioned embodiment. For example, in the above embodiment, a software keyboard displayed on the touch screen 12 of a PDA 10 was described as an example. However, the present invention can also be applied to mobile communication devices such as a mobile telephone. FIG. 8 is a perspective view showing one example of a mobile telephone using the present invention. As shown, the mobile telephone 100 is a folding-type device, and comprises a touch screen 101, a screen 102, a microphone 103, and a speaker 104. The present invention can also be applied to the software keyboard displayed on this touch screen 101.

Furthermore, the type of software keyboard used is not limited to the three types described above. For example, keyboard arrangements corresponding to various languages such as Hangul, Pinyin, or other keyboard arrangement images may also be included. In this case, the system may be devised so that the user can select in advance the keyboard arrangement images that are the objects of selection by the display unit 30.

## Claims

1. A character input device, comprising:
memory means (34) arranged to store three or more different types of keyboard arrangement images in an assigned order;
display means (30) arranged to display one of the three or more different types of keyboard arrangement images on a touch screen (12);
touch operation judgment means (31) arranged to judge whether or not a touch operation has been performed in a specified area of the touch screen (12); and
display switching control means (33) arranged to control the display means (30) so that one of the keyboard arrangement images among the keyboard arrangement images stored by the memory means (34), other than the keyboard arrangement image that is being displayed by the display means (30), is displayed,
wherein the character input device further comprises movement operation judgment means (32) arranged to judge whether or not a point of contact has moved in cases where the touch operation judgment means (31) has judged that a touch operation has been performed;
**characterized in that**
in cases where the movement operation judgment means (32) judges that the contact point has moved, the display switching control means (33) is arranged to control the display means (30) to select the one of the three or more types of keyboard arrangement images stored following a currently displayed keyboard arrangement image or the one of the three or more types of keyboard arrangement images stored preceding the currently displayed keyboard arrangement image in accordance with the direction of movement, and to display the selected keyboard arrangement image on the display means (30).

2. The character input device according to claim 1, wherein the display switching control means (33) is arranged to control the display means (30) to select the one of the three or more types of keyboard arrangement images stored preceding the currently displayed keyboard arrangement image in cases where an angle (θ) formed with a specified direction (L) by the direction of movement is 0 degrees or greater but less than 180 degrees, and to select the one of the three or more types of keyboard arrangement images stored following the currently displayed keyboard arrangement image in cases where the angle (θ) is 180 degrees or greater but less than 360 degrees.

3. The character input device according to claim 1 or 2, **characterized in that** the specified area of the touch screen (12) is an area other than the areas to which a key is assigned in the keyboard arrangement image that is being displayed by the display means (30).

4. The character input device according to any of claims 1 through 3, **characterized in that**:
the character input device is arranged to also functions as a telephone;
the memory means (34) is arranged to store dial key arrangement images in addition to the plurality of different types of keyboard arrangement images;
the character input device is arranged to be activated by either a keyboard operating mode, in which one of the keyboard arrangement images stored by the memory means (34) is displayed by the display means (30), or a dial key operating mode, in which a dial key arrangement image stored by the memory means (34) is displayed by the display means (30); and
the character input device further comprises operating mode switching means (35) is arranged to receive an operating mode switching operation performed by the user, and to switch the display produced by the display means (30) in accordance with the received switching operation.

5. A mobile communication device, **characterized by** comprising the character input device according to any of claims 1 through 4.

## Patentansprüche

1. Eine Zeichen-Eingabevorrichtung, aufweisend:
ein Speichermittel (34), das angeordnet ist, um drei oder mehr verschiedene Arten von Tastaturanordnungsbildern in einer zugewiesenen Reihenfolge zu speichern,
ein Anzeigemittel (30), das angeordnet ist, um eines von den drei oder mehr verschiedenen Arten von Tastaturanordnungsbildern auf einem Berührungsbildschirm (12) anzuzeigen,
ein Berührungsvorgang-Beurteilungsmittel (31), das angeordnet ist, um zu beurteilen, ob ein Berührungsvorgang in einem bestimmten Bereich des Berührungsbildschirms (12) durchgeführt wurde oder nicht, und
ein Anzeigeschaltsteuermittel (33), das angeordnet ist, um das Anzeigemittel (30) derart zu steuern, dass von den Tastaturanordnungsbildern, die von dem Speichermittel (34) gespeichert werden, eines der Tastaturanordnungsbilder, das ein anderes als das Tastaturanordnungsbild ist, das von dem Anzeigemittel (30) angezeigt wird, angezeigt wird,
wobei die Zeichen-Eingabevorrichtung ferner ein Bewegungsvorgang-Beurteilungsmittel (32) aufweist, das angeordnet ist, um zu beurteilen, ob ein Kontaktpunkt in Fällen, in denen das Berührungsvorgang-Beurteilungsmittel (32) beurteilt hat, dass ein Berührungsvorgang durchgeführt wurde, bewegt wurde oder nicht,
**dadurch gekennzeichnet, dass**
in Fällen, in denen das Bewegungsvorgang-Beurteilungsmittel (32) beurteilt, dass der Kontaktpunkt bewegt wurde, das Anzeigeschaltsteuermittel (33) angeordnet ist, um das Anzeigemittel (30) zu steuern, um das eine von den drei oder mehr Arten von Tastaturanordnungsbildern, das nach einem aktuell angezeigten Tastaturanordnungsbild gespeichert ist, oder das eine der drei oder mehr Arten von Tastaturanordnungsbildern, das vor dem aktuell angezeigten Tastaturanordnungsbild gespeichert ist, gemäß der Bewegungsrichtung auszuwählen und das ausgewählte Tastaturanordnungsbild auf dem Anzeigemittel (30) anzuzeigen.

2. Die Zeichen-Eingabevorrichtung gemäß Anspruch 1, wobei das Anzeigeschaltsteuermittel (33) angeordnet ist, um das Anzeigemittel (30) zu steuern, um das eine von den drei oder mehr Arten von Tastaturanordnungsbildern, das vor dem aktuell angezeigten Tastaturanordnungsbild gespeichert ist, in Fällen auszuwählen, in denen ein Winkel (θ), der mit einer bestimmten Richtung (L) durch die Bewegungsrichtung gebildet ist, 0 Grad oder größer, jedoch kleiner als 180 Grad ist, und um das eine von den drei oder mehr Arten von
Tastaturanordnungsbildern, das nach dem aktuell angezeigten Tastaturanordnungsbild gespeichert ist, in Fällen auszuwählen, in denen der Winkel (θ) 180 Grad oder größer, jedoch kleiner als 360 Grad ist.

3. Die Zeichen-Eingabevorrichtung gemäß Anspruch 1 oder 2, **dadurch gekennzeichnet, dass** der bestimmte Bereich des Berührungsbildschirms (12) ein anderer Bereich als die Bereiche ist, denen eine Taste in dem Tastaturanordnungsbild zugeordnet ist, das von dem Anzeigemittel (30) angezeigt wird.

4. Die Zeichen-Eingabevorrichtung gemäß irgendeinem der Ansprüche 1 bis 3, **dadurch gekennzeichnet, dass**:
die Zeichen-Eingabevorrichtung angeordnet ist, um auch als ein Telefon zu funktionieren,
das Speichermittel (34) angeordnet ist, um Wähltasten-Anordnungsbilder zusätzlich zu der Mehrzahl von verschiedenen Arten von Tastaturanordnungsbildern zu speichern,
die Zeichen-Eingabevorrichtung angeordnet ist, um durch entweder einen Tastaturbetätigungsmodus, in dem eines der von dem Speichermittel (34) gespeicherten Tastaturanordnungsbilder von dem Anzeigemittel (30) angezeigt wird, oder einen Wähltastenbetätigungsmodus, in dem ein von dem Speichermittel(34) gespeichertes Wähltastenanordnungsbild von dem Anzeigemittel (30) angezeigt wird, aktiviert zu werden, und
die Zeichen-Eingabevorrichtung ferner ein Betätigungsmodus-Schaltmittel (35) aufweist, das angeordnet ist, um einen von dem Benutzer durchgeführten Betätigungsmodus-Schaltvorgang zu empfangen und die Anzeige, die von dem Anzeigemittel (30) erzeugt wird, gemäß dem empfangenen Schaltvorgang umzuschalten.

5. Eine Mobilkommunikationsvorrichtung, **dadurch gekennzeichnet, dass** sie die Zeichen-Eingabevorrichtung gemäß irgendeinem der Ansprüche 1 bis 4 aufweist.

## Revendications

1. Un dispositif de saisie de caractères, comportant :
un moyen de mémoire (34) disposé pour mémoriser trois différents types d'images d'agencement de clavier ou davantage selon un ordre assigné,
un moyen d'affichage (30) disposé pour afficher un parmi les trois différent types d'images d'agencement de clavier ou davantage sur un écran tactile (12),
un moyen de jugement d'opération tactile (31) disposé pour juger si une opération tactile a été effectuée ou non dans une zone donnée de l'écran tactile (12), et
un moyen de contrôle de commutation d'affichage (33) disposé pour contrôler le moyen d'affichage (30) de sorte que parmi les images d'agencement de clavier enregistrées par le moyen de mémoire (34), une des images d'agencement de clavier autre que l'image d'agencement de clavier étant affichée par le moyen d'affichage (30) est affichée,
dans lequel le dispositif de saisie de caractères comprend en outre un moyen de jugement d'opération de mouvement (32) disposé pour juger si un point de contact s'est déplacé ou non dans les cas où le moyen de jugement d'opération tactile (31) a jugé qu'une opération tactile a été effectuée,
**caractérisé en ce que**
dans les cas où le moyen de jugement d'opération de mouvement (32) juge que le point de contact s'est déplacé, le moyen de contrôle de commutation d'affichage (33) est disposé pour contrôler le moyen d'affichage (30) pour choisir l'un parmi les trois types d'images d'agencement de clavier ou davantage mémorisé après une image d'agencement de clavier affichée actuellement ou l'un parmi les trois types d'images d'agencement de clavier ou davantage mémorisé avant l'image d'agencement de clavier affichée actuellement selon la direction de mouvement, et pour afficher l'image d'agencement de clavier choisie sur le moyen d'affichage (30).

2. Le dispositif de saisie de caractères selon la revendication 1, dans lequel le moyen de contrôle de commutation d'affichage (33) est disposé pour contrôler le moyen d'affichage (30) de manière à choisir l'un parmi les trois types d'images d'agencement de clavier ou davantage mémorisé avant l'image d'agencement de clavier affichée actuellement dans les cas où un angle (θ) formé avec une direction donnée (L) par la direction de mouvement est 0 degrés ou plus mais inférieur à 180 degrés, et de manière à choisir l'un parmi les trois types d'images d'agencement de clavier ou d'avantage mémorisé après l'image d'agencement de clavier affichée actuellement dans les cas où l'angle (θ) est 180 ou plus mais inférieur à 360 degrés.

3. Le dispositif de saisie de caractères selon la revendication 1 ou 2, **caractérisé en ce que** la zone donnée de l'écran tactile (12) est une zone autre que les zones auxquelles une touche est assignée dans l'image d'agencement de clavier qui est affichée par le moyen d'affichage (30).

4. Le dispositif de saisie de caractères selon l'une quelconque des revendications 1 à 3, **caractérisé en ce que** :
le dispositif de saisie de caractères est disposé pour fonctionner également comme téléphone,
le moyen de mémoire (34) est disposé pour mémoriser des images d'agencement de touches de numérotation outre la pluralité de différents types d'images d'agencement de clavier,
le dispositif de saisie de caractères est disposé pour être activé soit par un mode d'opération de clavier dans lequel une parmi les images d'agencement de clavier mémorisées par le moyen de mémoire (34) est affichée par le moyen d'affichage (30), soit par un mode d'opération de touches de numérotation, dans lequel une image d'agencement de touches de numérotation mémorisée par le moyen de mémoire (34) est affichée par le moyen d'affichage (30), et
le dispositif de saisie de caractères comprend en outre un moyen de commutation de mode d'opération (35) disposé pour recevoir une opération de commutation de mode d'opération effectuée par l'utilisateur, et pour commuter l'affichage produit par le moyen d'affichage (30) selon l'opération de commutation reçue.

5. Un dispositif de communication mobile, **caractérisé par** comportant le dispositif de saisie de caractères selon l'une quelconque des revendications 1 à 4.
